# EUROPÄISCHE PATENTSCHRIFT

(11) **EP 1 923 926 B1**
(45) Veröffentlichungstag und Bekanntmachung des Hinweises auf die Patenterteilung: **12.01.2011**
(21) Anmeldenummer: 06291793.5
(22) Anmeldetag: 17.11.2006
(51) Int. Cl.: H01L 39/24

(54) **Verfahren zur Herstellung eines supraleitfähigen elektrischen Leiters**
Method of manufacturing a superconducting electrical conductor
Procédé de fabrication pour un conducteur électrique supraconducteur

(43) Veröffentlichungstag der Anmeldung: 21.05.2008
(73) Patentinhaber: Nexans, 75008 Paris (FR)
(72) Erfinder: Allais, Arnaud, Dr., 22940 Saint Julien (FR); Isfort, Dirk, Dr. rer. nat., 50321 Brühl (DE)
(74) Vertreter: Döring, Roger

(56) Entgegenhaltungen:
- EP-A1- 0 977 282
- WO-A-97/17733
- WO-A-2004/059041
- US-A- 5 872 081
- US-A- 5 968 877
- US-B1- 6 436 317

## Beschreibung

Die Erfindung bezieht sich auf ein Verfahren zur Herstellung eines supraleitfähigen elektrischen Leiters gemäß dem Oberbegriff des Patentanspruchs 1.

Ein solches Verfahren geht aus der EP 0 977 282 A1 hervor.

Ein supraleitfähiger elektrischer Leiter besteht aus einem speziellen Material, das bei ausreichend tiefen Temperaturen in den supraleitfähigen Zustand übergeht. Der elektrische Widerstand eines entsprechend aufgebauten Leiters geht dadurch gegen Null. Geeignete supraleitfähige Materialien sind beispielsweise YBCO (Yttrium-Barium-Kupfer-Oxid) oder BSCCO (Wismut-Strontium-Kalzium-Kupfer-Oxid). Ausreichend niedrige Temperaturen für derartige keramische Materialien liegen beispielsweise zwischen 4 K und 110 K, um den supraleitfähigen Zustand zu erreichen. Entsprechende supraleitfähige Leiter werden als Hochtemperatur-Supraleiter bezeichnet. Geeignete Kühlmittel sind beispielsweise Stickstoff, Helium, Neon und Wasserstoff oder Gemische dieser Stoffe, jeweils in flüssigem Zustand.

Die US-A-5 739 086 beschreibt unterschiedliche Verfahren zur Herstellung von Hochtemperatur-Supraleitern. Bei einem BSCCO-Supraleiter wird das BSCCO-Material beispielsweise in Pulverform in ein Rohr aus Silber eingefüllt und verdichtet. Durch mechanische Verformung des Rohres und anschließende Wärmebehandlung (Glühen) wird der supraleitfähige Zustand erreicht. Beim YBCO-Supraleiter, der wegen seiner hervorragenden elektrischen Eigenschaften besonders für elektrische Kabel und Wicklungen geeignet ist, wird auf ein beispielsweise biaxial texturiertes Band aus Metall als Substrat zunächst eine ebenfalls aus Metall bestehende Pufferschicht aufgebracht, auf welche anschließend das YBCO-Material aufgetragen wird. Das Substrat besteht beispielsweise aus Nickel, Kupfer oder Eisen oder einer Legierung. Für die Pufferschicht werden beispielsweise Kupfer oder Silber eingesetzt. Das YBCO-Material wird abschließend ebenfalls durch Wärmebehandlung in den supraleitfähigen Zustand gebracht. Der so hergestellte supraleitfähige Leiter kann - wie schon erwähnt - mit Vorteil in elektrischen Kabeln sowie Wicklungen für elektrische Motoren und Magnete eingesetzt werden. Er kann dabei aber wegen der Bandform nur in einer Richtung gebogen werden.

Aus der eingangs erwähnten EP 0 977 282 A geht ein Verfahren zur Herstellung eines supraleitfähigen elektrischen Leiters hervor, bei welchem eine Schicht aus einem Yttrium-Barium-Kupfer-Oxid (YBCO) als supraleitfähigem Material auf eine metallische Unterlage aufgebracht und einer Wärmebehandlung unterzogen wird. Dazu wird auf einen langgestreckten metallischen Träger mit kreisförmigem Querschnitt rundum eine Zwischenschicht aus Material aufgebracht, das mit der Kristallstruktur von YBCO verträglich ist. Der mit der Zwischenschicht versehene Träger wird anschließend so behandelt, daß die Zwischenschicht als metallische Unterlage für YBCO-Material eine vorgegebene Texturierung erhält. Danach wird um den mit der texturierten Zwischenschicht versehenen Träger direkt die Schicht aus supraleitfähigem YBCO-Material rundum herumgeformt. Abschließend wird die Wärmebehandlung durchgeführt.

Der Erfindung liegt die Aufgabe zugrunde, das eingangs geschilderte Verfahren so zu gestalten, daß sich ein leichter zu verarbeitender und mechanisch stabiler supraleitfähiger Leiter auf YBCO-Basis ergibt.

Diese Aufgabe wird gemäß dem kennzeichnenden Merkmal des Patentanspruchs 1 gelöst.

Mit diesem Verfahren ist ein in den supraleitfähigen Zustand überführbarer elektrischer Leiter mit kreisförmigem Querschnitt geschaffen, dessen supraleitfähige Schicht fest mit ihrer Unterlage verbunden ist, so daß sie allen beim Weiterverarbeiten des Leiters entstehenden mechanischen Anforderungen genügt. Der Leiter kann somit in gleicher Weise wie herkömmliche drahtförmige Leiter verarbeitet werden. Eine besondere Richtung beim Biegen des Leiters ist nicht mehr erforderlich. Er eignet sich daher besonders zur Herstellung von Wicklungen für elektrische Motoren und Magneten, aber auch für den Aufbau elektrischer Kabel unter Einsatz herkömmlicher Vorrichtungen.

Das Verfahren nach der Erfindung wird anhand der Zeichnungen als Ausführungsbeispiel erläutert.

Es zeigen:
Fig. 1 schematisch eine Anordnung zur Durchführung des Verfahrens nach der Erfindung.
Fig. 2 und 3 Schnittbilder aus Fig. 1 längs der Linien II - II und III - III in vergrößerten Darstellungen.
Fig. 4 einen Querschnitt durch einen mit dem Verfahren herstellbaren supraleitfähigen Leiter.

Mit 1 ist ein metallischer Träger bezeichnet, der als Strang, Seil oder Rohr ausgeführt sein kann. Er hat einen kreisrunden Querschnitt und besteht vorzugsweise aus Stahl. Der Träger 1 kann auch als zugfestes zentrales Element für einen herzustellenden supraleitfähigen Leiter dienen. Der Träger 1 hat vorzugsweise einen zwischen 0,5 mm und 3,0 mm liegenden Außendurchmesser.

Auf den Träger 1 wird in einer Vorrichtung 2 rundum eine Zwischenschicht 3 aufgebracht, die als metallische Unterlage für eine Pufferschicht dient, auf welche eine YBCO-Schicht aufgebracht wird. Die Zwischenschicht 3 besteht aus einem metallischen Material, wie beispielsweise Nickel, Kupfer oder Eisen oder einer Legierung, das mit der Struktur der zum Auftragen von YBCO geeigneten Pufferschicht verträglich ist. Zum Auftragen der Zwischenschicht 3 können übliche Beschichtungsverfahren eingesetzt werden, wie beispielsweise das PVD-Verfahren (Physical Vapor Deposition), das CVD-Verfahren (Chemical Vapor Deposition) oder das CSD-Verfahren (Chemical Solution Deposition). Das PVD-Verfahren kann alle gängigen Vakuumbeschichtungsverfahren umfassen, wie beispielsweise Sputtern, Elektronenstrahlverdampfen und Bogenverdampfen sowie auch ionenunterstützte Verfahren.

Das Material der Zwischenschicht 3 wird mit einer Wandstärke aufgetragen, die mit Vorteil zwischen 20 nm und 1 mm liegt. Anschließend wird der beschichtete Träger 1 in einer Anlage 4 so behandelt, daß die Zwischenschicht 3 eine ausgeprägte Texturierung mit einer gezielten Ausrichtung der Kristalle erhält, bei der möglichst alle Kristalle parallel zueinander ausgerichtet sind. Der Träger 1 ist dann von einer rundum geschlossenen, texturierten Unterlage für eine Pufferschicht umgeben, auf welche das YBCO-Material aufgetragen wird.

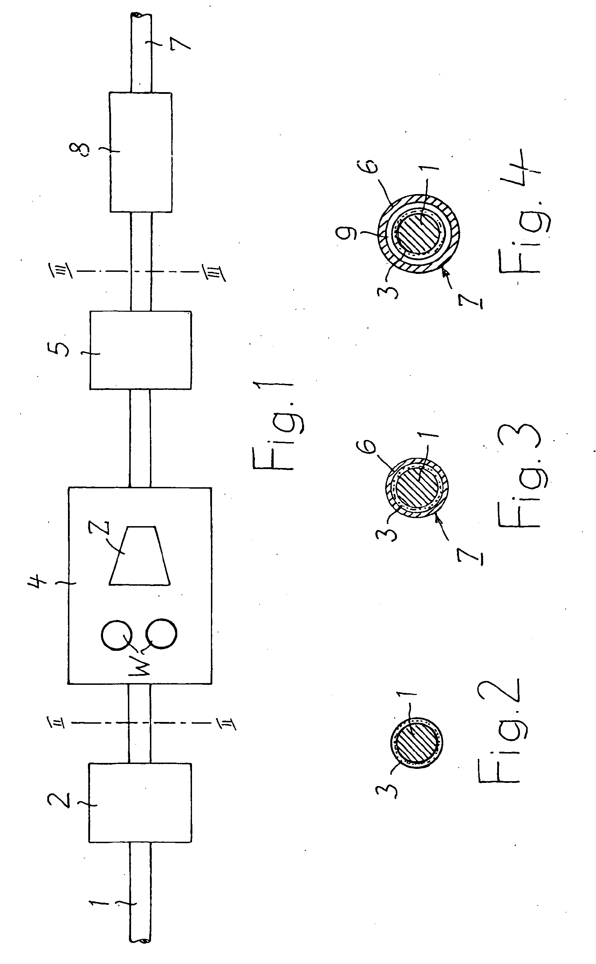

Die Texturierung der Zwischenschicht 3 kann mechanisch oder thermisch oder mit Vorteil mechanisch/thermisch oder auch durch Anwendung eines Magnetfeldes erhalten werden. Bei einer mechanischen Behandlung kann der beschichtete Träger 1 beispielsweise gewalzt oder mit besonderem Vorteil durch mindestens einen Ziehstein zur Reduzierung des Durchmessers gezogen werden. Entsprechende Vorrichtungen "W" und "Z" sind in Fig. 1 in der Anlage 4 schematisch angedeutet. Bei einer mit Vorteil durchführbaren thermomechanischen Behandlung kann die Dicke der Zwischenschicht 3, welche den Träger 1 umschließt, durch Ziehen auf etwa 1 % bis 5 % ihres ursprünglichen Querschnittes in einem Temperaturbereich zwischen Raumtemperatur und 300°C reduziert werden. Die Reduktion sollte idealerweise in mehreren Schritten erfolgen, z. B. mit nicht mehr als 10 % Querschnittsreduktion pro Schritt. Im Anschluß daran kann mit Vorteil eine Rekristallisationsglühung bei 700°C bis 1200°C erfolgen. Die Temperatur hängt dabei von der für die Zwischenschicht 3 verwendeten Legierung ab. Für reines Nickel ist eine Temperatur von 700°C anwendbar, während bei einer Nickellegierung mit einem Zusatz von 5 % Wolfram Temperaturen von 1000 °C bis 1100 °C aufzubringen wären.

Für eine durch magnetische Behandlung zu bewirkende Ausrichtung der Kristalle kann der mit der Zwischenschicht 3 umhüllte Träger 1 in der Anlage 4 durch ein entsprechend kräftiges Magnetfeld gezogen werden.

Nach der geschilderten Behandlung der Zwischenschicht 3 wird zu ihrem Schutz auf dieselbe eine rundum geschlossene Pufferschicht 9 (Fig. 4) mit einer Dicke von beispielsweise 100 nm bis 200 nm aufgetragen, die aus Keramik besteht. Geeignete Materialien sind beispielsweise Cerium-Oxid oder Lanthan-Zirkonium-Oxid. Die Pufferschicht 9 kann mit den gleichen Beschichtungsverfahren aufgebracht werden, wie sie für die Zwischenschicht 3 angegeben sind.

Auf die Pufferschicht 9 wird dann in einer Anlage 5 rundum eine Schicht 6 aus YBCO-Material aufgetragen werden, deren Dicke mit Vorteil zwischen 1 µm und 5 µm liegen kann. Das kann wieder mit den schon erwähnten, an sich bekannten Beschichtungsverfahren geschehen, nämlich beispielsweise dem PVD-Verfahren, dem CVD-Verfahren oder dem CSD-Verfahren. Hinter der Anlage 5 liegt dann ein mit supraleitfähigem YBCO-Material beschichteter, runder Leiter 7 vor, der abschließend in einer Einrichtung 8 zum Erreichen der Supraleitfähigkeit einer Wärmebehandlung unterzogen wird, vorzugsweise geglüht wird. Das kann mit Vorteil bei Temperaturen von 700°C bis 850 °C durchgeführt werden.

Die Pufferschicht 9 kann beispielsweise aus Lanthanazetylazetonat/Zirkonazetylazetonat (La2Zr2O7) bestehen. Sie wird beispielsweise durch Tauchbeschichten der Zwischenschicht 3 in einer Lösung erhalten, in welcher die angegebenen Materialien in Propionsäure gelöst sind. Der Träger 1 wird dabei durch die Lösung gezogen. Eine flüssige Schicht, die im Anschluß trocknet (das Lösungsmittel verdampft), verbleibt dabei gleichmäßig auf der Oberfläche des Trägers 1. Die getrocknete Schicht wird dann durch einen Temperofen bei 1000°C geführt, so daß organische Bestandteile zersetzt und mit dem Prozeßgas abgeführt werden. Zurück bleibt als Zwischenschicht 3 eine epitaktisch aufgewachsene La2Zr2O7-Schicht, auf die anschließend die Schicht 6 aus YBCO-Material ebenfalls epitaktisch aufgebracht werden kann.

## Patentansprüche

1. Verfahren zur Herstellung eines supraleitfähigen elektrischen Leiters, bei welchem eine Schicht aus einem Yttrium-Barium-Kupfer-Oxid (YBCO) als supraleitfähigem Material auf eine metallische Unterlage aufgebracht und einer Wärmebehandlung unterzogen wird, bei welchem auf einen langgestreckten metallischen Träger (1)mit kreisförmigem Querschnitt rundum eine Zwischenschicht (3) aufgebracht wird, bei welchem der mit der Zwischenschicht (3) versehene Träger (1) anschließend so behandelt wird, daß die Zwischenschicht (3) als metallische Unterlage für die Schicht (6) aus YBCO-Material eine vorgegebene Texturierung erhält, bei welchem um den mit der Zwischenschicht (3) versehenen Träger (1) die Schicht (6) aus supraleitfähigem YBCO-Material rundum herumgeformt wird und bei welchem abschließend die Wärmebehandlung durchgeführt wird, **dadurch gekennzeichnet, daß** die zwischenschicht aus einem metallischen Material besteht, welches mit der Kristallstruktur von YBCO verträglich ist , und
daß nach der Texturierung der Zwischenschicht (3) zunächst eine zum Auftragen von YBCO geeignete, rundum geschlossene Pufferschicht (9) auf dieselbe aufgetragen wird, welche aus Keramik besteht und eine zwischen 100 nm und 200 nm liegende Dicke hat, auf welche dann die Schicht (6) aus YBCO-Material aufgebracht wird

2. Verfahren nach Anspruch 1, **dadurch gekennzeichnet, daß** als Ausgangsmaterial für die Pufferschicht (9) Lanthanazetylazetonat/Zirkonazethylazetonat verwendet wird.

3. Verfahren nach Anspruch 1 oder 2, **dadurch gekennzeichnet, daß** die Zwischenschicht (3) durch mechanische Verformung texturiert wird.

4. Verfahren nach Anspruch 1 oder 2, **dadurch gekennzeichnet, daß** die Zwischenschicht (3) durch thermische Behandlung texturiert wird.

5. Verfahren nach Anspruch 1 oder 2, **dadurch gekennzeichnet, daß** die Zwischenschicht (3) durch thermomechanische Behandlung texturiert wird.

6. Verfahren nach Anspruch 1 oder 2, **dadurch gekennzeichnet, daß** die Zwischenschicht (3) durch Anwendung eines Magnetfeldes texturiert wird.

## Claims

1. A method for producing of a superconductive electrical conductor, by which a layer of yttrium-barium-copper-oxide (YBCO) is applied as a superconductive material onto a metal base and afterwards thermally treated, by which an intermediate layer(3) is applied all around to an elongated metallic support (1) having a circular cross-section, by which the support (1) provided with the intermediate layer (3) is subsequently processed such that the intermediate layer (1) as metallic base for the layer(6) of YBCO-material receives a predetermined texturing, by which the layer (6) of YBCO-material is formed all around the support (1) which carries the intermediate layer(3) and by which finally the heat treatment is carried out, **characterized in that** the intermediate layer(3) consists of a metallic material, which incompatible with the crystal structure of YBCO, and tha t a fte r the texturing of the intermediate layer(3) a circularly closed buffer layer (9) is applied to the same, which is suitable for the application of YBCO and c o nsists of ceramic and which ha s a thickness between 100 nm and 200 nm.

2. Method according to claim 1, **characterized in that** lanthanacetylacetonate/zirconacethylacetonate is used as starting material for the bufferlayer (9).

3. Method according to claim 1 or 2, **characterized in that** the interlayer (3) is textured by mechanic al shaping.

4. Method according to claim 1 or 2, **characterized in that** the interlayer (3) is textured by heat treatment.

5. Method according to claim 1 or 2, **characterized in that** the interlayer (3) is textured by thermomechanical processing.

6. Method according to claim 1 or 2, **characterized in that** the interlayer (3) is textured by applying a magnetic field.

## Revendications

1. Procédé de fabrication d'un conducteur électrique supraconducteur, selon lequel une couche d'un oxyde d'yttrium baryum cuivre (YBCO-) en tant que matériau supraconducteur est appliquée sur un support métallique et soumise à un traitement thermique, selonlequelune couche intermédiaire (3) est appliquée surle pourtour d'un support métallique allongé (1) ayant une section transversale circulaire, selon lequelle support (1) muni de la couche intermédiaire (3) est ensuite soumis à un traitement de telle sortie que la couche intermédiaire (3), en tant que support métallique pour la couche (6) en matériau YBCO-, prend une texture prédéfinie, selon lequel la couche (6) en matériau YBCO supraconducteur est façonnée sur le pourtour autour du support (1) muni de la couche intermédiaire (3) et selon lequelle traitement thermique est finalement réalisé, **caractérisé en ce que** la couche intermédiaire se compose d'un matériau métallique qui est compatible avec la structure cristalline du YBCO et qu'après la prise de texture parla couche intermédiaire (3), une couche tampon (9) appropriée pour l'application de YBCO et au pourtour fermé est tout d'abord appliquée sur celle-ci, laquelle se compose de céramique et présente une épaisseur comprise entre 100 nm et 200 nm et sur laquelle la couche (6) en matériau YBCO estensuite appliquée.

2. Procédé selon la revendication 1, **caractérisé en ce que** la matière première utilisée pour la couche tampon (9) est du lanthanum acétylacétonate / zirconium acétylacétonate.

3. Procédé selon la revendication 1 ou 2, **caractérisé en ce que** la couche intermédiaire (3) est texturée par déformation mécanique.

4. Procédé selon la revendication 1 ou 2, **caractérisé en ce que** la couche intermédiaire (3) est texturée par traitement thermique.

5. Procédé selon la revendication 1 ou 2, **caractérisé en ce que** la couche intermédiaire (3)est texturée par traitement thermomécanique.

6. Procédé selon la revendication 1 ou 2, **caractérisé en ce que** la couche intermédiaire (3) est texturée en utilisant un champ magnétique.
